# EUROPEAN PATENT APPLICATION

(11) **EP 1 283 422 A1**
(43) Date of publication of application: **12.02.2003**
(21) Application number: 01306719.4
(22) Date of filing: 07.08.2001
(51) Int. Cl.: G01R 31/3183, G06F 17/50

(54) **Testbench for the validation of a device under test**

(71) Applicant: LUCENT TECHNOLOGIES INC., Murray Hill, New Jersey 07974-0636 (US)
(72) Inventor: Heinkel, Ulrich, Uttenreuth 91080 (DE); Knaeblein, Joachim, Erlangen 91054 (DE); Mayer, Claus, Eggolsheim 91330 (DE)
(74) Representative: Sarup, David Alexander

(57) **Abstract**

The invention relates to a testbench (10) for the validation of data stream oriented multi-million-gate ASICs (50), in particular for telecommunication circuits.

The testbench (10) according to the invention comprises a data generator (30), a data analyser (40) and a CPU interface (20) for controlling the testbench (10) itself and the ASIC (50) in dependence on the simulation results.

This reactive simulation based approach allows to deal with highest complexities without restricting too much with respect to the validation environment. This is achieved by using standard VHDL constructs. Due to performance issues, computational expensive algorithms are coded in C++. There is, however, no need for large and slow file I/O-operations and the input stimuli (35) are preferably modified interactively.

Formal methods can be incorporated in the design specification phase in order to generate better quality testcases semi-automatically. Because of the size of the ASICs (50) validated certain critical system properties can be proved on specification level and the correct implementation via conventional simulation runs can be assured.

## Description

### Field of the Invention

The invention generally relates to a testbench for the validation of a device under test and, particularly, of a data stream oriented multi-million-gate ASIC.

### Background of the Invention

Integrated circuits, e.g. ASICs and their programmable counterparts (e.g. FPGAs) have become very popular in recent years due to their very large scale integration and their flexibility. Also in this field there is an ever-increasing demand in the semiconductor industry towards smaller structures which has led to "Systems-on-a-Chip" type designs. Code re-use and appropriate partitioning into sub-modules are common practice to deal with the pure design work.

For assuring a proper operation those integrated circuits are validated, i.e. their functionality is tested. The validation of high gate count application specific integrated circuits (ASIC), however, has become the bottleneck of the system design process due to ever increasing complexities of integrated circuits often exceeding some million gates. Furthermore, this is due to the fact that a final top-level check of the proper interaction of the system components is necessary where the validation team has to deal with the complete design.

A major field of application for ASICs and, consequently for ASIC validation, is the optical transmission of telecommunication data, in particular according to the Synchronous Optical Network (SONET) standard and its European equivalent, the Synchronous Digital Hierarchy (SDH) standard.

Therefore, the following description is focused on SONET/SDH application. It is, however, clear to those skilled in the art, that the present invention is also applicable to nearly any other kinds of integrated circuits.

It is not just the overall design complexity of SONET/SDH ASICs that poses a problem but also the application field itself. SONET and SDH define a worldwide integrated network standard on which all types of traffic can be transported. It is mainly used for interconnection between different service providers via high capacity optical fibre networks.

The basic functionality of SONET/SDH designs is fairly simple as in- and output are continuous data streams. The information bits are arranged into complex containers consisting of bytes, rows, columns, frames, etc. Once the data stream or chip is synchronised to the incoming data, the processing operations are mostly some sort of (de-)multiplexing. Unlike for example processor cores or specialised data decoders, controller functions of the ASIC are either event driven, e.g. if the incoming signal is lost, or quasi-static, i.e. the configuration of the ASIC is modified only if the data link is changed.

An exemplary application is the generation of a new high speed data stream by grouping several low speed input packets into a new container. Network management requires the supervision of dedicated overhead bytes, e.g. a trace identifier byte is compared with an expected value in order to check the correct interconnection. If the received value does not match the default, an error indication signal is transmitted in the out-going data stream.

A main task of top-level validation engineers is the generation of data patterns that allow to test for the required system behavior. Due to the complex protocol the input data stream is generated by dedicated tools outside of the very high speed integrated circuit hardware description language (VHDL) environment. A detailed description of the VHDL can be found in Heinkel et al., "The VHDL Reference", John Wiley & Sons, ISBN 0-471-89972, the disclosure of which is incorporated by reference herewith.

Up to know, an ASIC testbench is typically formed by a number of modules which stimulate an ASIC or, more generally a device under test (DUT). Those modules are typically realised as a huge input file of digital data which is fed into the device under test. Additionally, there might be blocks which receive the simulation data and preprocess it in a relatively simple way.

However, the main work is done by a developer which investigates the information to find out whether the device under test does what is supposed to do. E.g. the tedious analysis process has to be done mainly by the person who is responsible for the verification. Verification effort is wasted by manually checking the simulation results and, in principle, such kind of manual verification is not able to keep track with the rising complexity of integrated circuits which is feasible physically in silicon.

Furthermore, the input patterns are typically generated prior to simulation. Thus, only small changes to the flow of a testcase are possible, e.g. by forcing internal signals by hand via the simulator being rather inflexible and, again wasting man-power.

### Summary of the Invention

Therefore, it is an object of the present invention to provide an improved testbench, method and computer program product for the validation of a device under test or an integrated circuit overcoming or at least diminishing the disadvantages of the prior art.

A further object of the present invention is to provide a flexible testbench, method and computer program product which facilitates the validation of a device under test, reducing the overall effort, time and costs.

Still a further object of the present invention is to provide a testbench, method and computer program product for the validation of a device under test which enables interaction between the testbench and the device under test and/or between modules of the testbench.

The object of the invention is achieved in a surprisingly simple manner by subject matter of claims 1, 27 and 29.

The testbench for the validation of a device under test, e.g. an integrated circuit and, in particular an ASIC or an FPGA, comprises data providing means, preferably a data generator, for providing said device under test with input data. Said input data are preferably processed by said device under test. The testbench further comprises a data analyser for analysing output data received from said integrated circuit and a controller which is adapted to be assigned to the device under test.

An advantage of the testbench according to the invention is the fact, that the controller is able to provide interaction between the data providing means stimulating the device under test and the data analyser analysing the simulation results.

Furthermore, the testbench according to the invention allows engineers to develop their test cases on a higher abstraction level and, as a further advantageous effect, those test cases become reusable.

Moreover, the testbench avoids large and slow file I/O-operations.

Preferably, the device under test or integrated circuit comprises or is a protocol-based data stream processing unit, e.g. an FPGA or an ASIC, in particular a multi-million-gate ASIC for optical channel data transmission applications.

In a preferred embodiment, the data providing means and/or the data analyser are assigned or connected to the integrated circuit. Particularly, the device under test comprises a data input to feed input data from the data providing means. Those data are then processed by the integrated circuit providing the output data being transmitted via a data output of the integrated circuit to the data analyser.

In a further preferred embodiment of the invention, the controller controls and/or observes the integrated circuit, the data providing means and/or the data analyser.

Preferably, the controller communicates interactively with the data providing means, the data analyser and/or the integrated circuit. Such interaction between the testbench modules, represented by at least the data providing means, the analyser and the controller advantageously allows the data providing means or stimulation generator to react dynamically to simulation results, e.g. the data received by the data analyser for the further control of the data providing means and the integrated circuit.

As an example, the controller which preferably comprises or is a CPU interface, reacts to interrupts of the integrated circuit and reconfigures the data providing means in dependence on the reaction to the interrupts. As an example, this reconfiguration includes changing of the data transmission mode and/or a reset of the integrated circuit and/or polling for an event or delta, e.g. from the integrated circuit. This enables the testbench to react to unexpected behaviour dynamically at simulation runtime. The simulation control is very flexible, such that not necessarily all simulation circumstances have to be anticipated as within prior art concepts. According to the invention, a new verification set-up can be saved eventually.

Preferably, the testbench is event-driven and the commands of the controller are synchronised to the frame or super frame of the data input provided by the data providing means. This approach serves for very much flexibility of the testbench.

Furthermore, test cases coming from earlier block level design can be re-used during the top level verification phase. This, advantageously, reduces the effort for implementation of the top level testbench. Tests working on block level can be reproduced on top level.

Preferably, the testbench, in particular the controller comprises means to provide the device under test with a verification support code which, e.g. is added to the code to be checked or to the design description and testcases from block level simulation are reusable on toplevel, despite the heavily differing test environments on block and top level. This considerably simplifies the evaluation of the verification results or even enables some requirement checks which were hard to realise with prior art concepts.

Consequently, the invention provides an overall effort reduction concerning the verification process. These savings can be spent for verification of additional functions. As integration capabilities proceed, more and more functions are feasible with the integrated circuit. According to the invention, the verification time per function is advantageously reduced, enabling to provide more functions in the same or less time.

Preferably, the controller is assigned or connected to the integrated circuit by a control interface, e.g. a CPU BUS, which is preferably bi-directional for receiving event data from the integrated circuit and/or for transmitting control data from the controller to the integrated circuit.

In a further preferred embodiment, the controller comprises a further interface assigned or connected to the integrated circuit to receive one or more interrupts from the integrated circuit. Preferably, the testbench or particularly the controller is adapted for the validation of an integrated circuit with interrupt handling or particularly cascaded interrupt handling.

According to a preferred development of the invention, the testbench, more specifically the controller and/or the data providing means and/or the data analyser store control commands and/or input data and/or received or analysed data into a preferably common simulation log file.

In a further preferred development of the invention, the controller, the data providing means and/or the integrated circuit comprise a clock/reset generator, which is also controlled by the controller.

It is clear to those skilled in the art, that the testbench can be hardware- or software-based, e.g. it can be realised as software or computer program product running on a conventional computer. In this case, the controller, the data providing means and/or the data analyser are preferably realised as program modules linked together to form the testbench. An object oriented program language as C or C++ or a hardware description language, e.g. VHDL is preferably used. The testbench or at least the controller are preferably programmable, e.g. through a command file.

A further preferred and very advantageous embodiment of the invention provides an automatic generation of behavioural VHDL models or controller command files and/or an automatic conversion of a formal specification description to testcase control files.

The invention is described in more detail and in view of preferred embodiments hereinafter. Reference is made to the attached drawings.

### Brief Description of the Figures

It is shown in
- Fig. 1: a block diagram of the testbench according to the invention,
- Fig. 2: the structure of a possible frame format (e.g. the OCh super frame of an optical network data stream) and
- Fig. 3: an example of a formal design specification.

### Detailed Description of the Invention

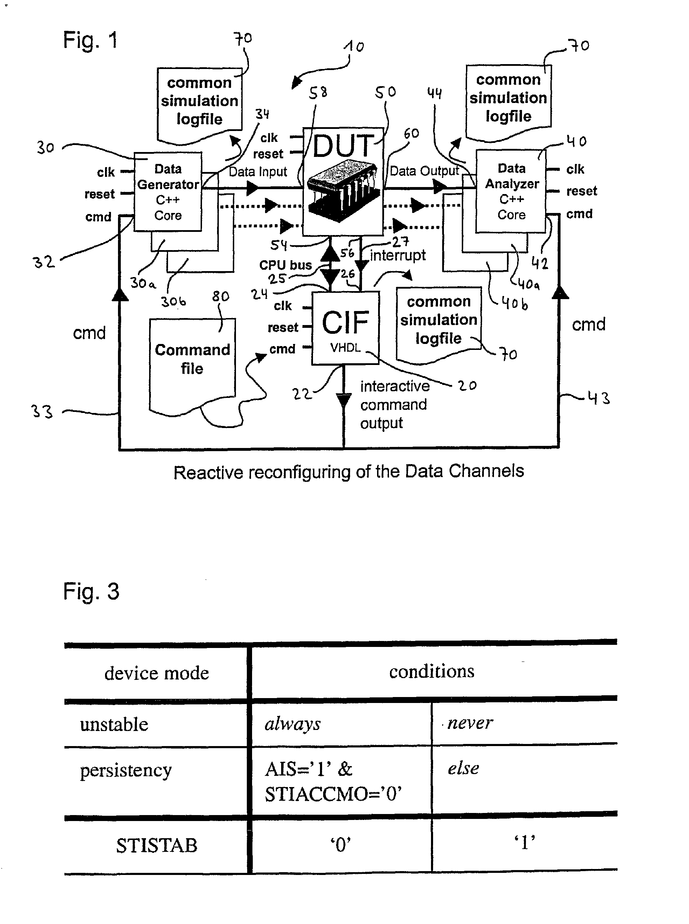

Fig. 1 shows an exemplary testbench 10 comprising a controller 20, a data providing means 30 and a data analyser 40. Furthermore, a device under test (DUT) 50 or an integrated circuit is depicted. In this preferred embodiment, the controller is realised as CPU interface (CIF) 20 and the data providing means is realised as data generator (30).

The CPU interface 20 comprises an interactive command interface or interactive command output 22 which is connected or assigned to both, command inputs of the data generator and the data analyser 32, 42 by command lines 33 and 43, respectively. The CPU interface 20 controls the data generator 30 and the data analyser 40 by the command lines 33 and 43.

A second interface 24 of the CPU interface 20 is connected bi-directionally with interface 54 of the device under test 50 by a CPU BUS 25. Furthermore, a third interface 26 of the CPU interface 20 is connected with an interrupt output 56 of the device under test 50 by an interrupt line 27 to transmit interrupts from the device under test 50 to the CPU interface 20.

An output 34 of the data generator 30 is assigned to or connected with data input 58 of the device under test 50 to feed the device under test 50 with input data from the data generator 30. Those data are processed by the device under test 50 and transmitted via data output 60 to an input 44 of the data analyser 40 to verify the regular operation of the device under test, e.g. an ASIC. Consequently, preferably all components, i.e. the CPU interface 20, a data generator 30, the integrated circuit 50 and the data analyser 40 communicate interactively with one another.

Furthermore, the CPU interface 20, the data generator 30, the data analyser 40 and the integrated circuit 50 have a clock interface clk and a reset interface reset. Moreover, the simulation results, e.g. interrupts received from the integrated circuit 50 by the CPU interface 20, data or commands exchanged by the CPU BUS 25, commands of the CPU interface 20 provided to the data generator 30 and data analyser 40 by command lines 33, 43, the data input for the integrated circuit 50 provided by data generator 30 and/or the data output of the integrated circuit 50 provided to the data analyser 40 are written into a common simulation log file 70.
An example of a simulation log file is shown in Table 2.

In addition, the CPU interface 20 comprises a command input or command interface for receiving commands from a command file 80. An example of a command file 80 is shown in Table 1.

Referring back to Fig. 1, second and third data generators 30a, 30b and second and third data analysers 40a, 40b are shown, being equivalent to data generator 30 and data analyser 40, respectively, for simulating 3 multiplexed data streams. It is clear to those skilled in the art, that the number of 3 data generators 30, 30a, 30b and 3 data analysers, 40, 40a, 40b is exemplary chosen. The number of data generators and data analysers can be adapted to nearly any number of multiplexed data streams, most preferably this number is 2, 4, 10, 16 or higher.

The exemplary embodiment of the invention shown in Fig. 1 provides a VHDL/C++ testbench environment 10 that allows stimuli generation and response validation of a device under test 50 or an integrated circuit to be done interactively during the simulation or in batch processing mode on various simulation platforms (Cadence ncsim and MTI modeltech VHDL simulators, IKOS Voyager hardware accelerator).

The communication between the device under test 50, which is exemplary embodied by an ASIC and the testbench 10 is done by the controller 20 which is realised as an innovative central processing unit (CPU) interface written in behavioral VHDL. The CPU interface (CIF) 20 uses a scripting command language with e.g. symbolic addressing, subprogram calls, includes file handling, variables, simple if-statements etc. and a command for communicating interactively with the rest of the testbench 10. It is a master control block for the data or stimuli generator 30 or generators, the data or response analyser 40 or analysers and the device under test interface.

The testbench 10 can react dynamically on device under test interrupts and can send new commands to the data generator 30 or the data analyser 40. All these actions or interactive commands are stored in the simulation log file 70, so it is easily possible to create a set of commands for regression simulations in batch mode.

The inventors have used this environment or testbench 10 for the verification or validation of a 2.2 million gates ASIC for a SONET/SDH application. Most of the requirements (> 300) have been verified using the RT level VHDL description. Some special requirements concerning the clock distribution have been verified with the Verilog gate level netlist together with the same testbench environment 50.

The functionality of the basic device under test or ASIC 50, in this case, is the processing of a continuous data input-/output stream in an optical high speed data network (10 GBps) which is the preferred field of application for the invention. During normal operation, high speed bipolar multiplexers divide the incoming data frequency to a CMOS compatible one resulting in a data clock rate of 622 MHz per two bytes.

Known optical transmission systems perform error correction instead of much simpler error detection. Therefore, the traditional SONET/SDH protocol was modified in order to allow for additional redundant information.

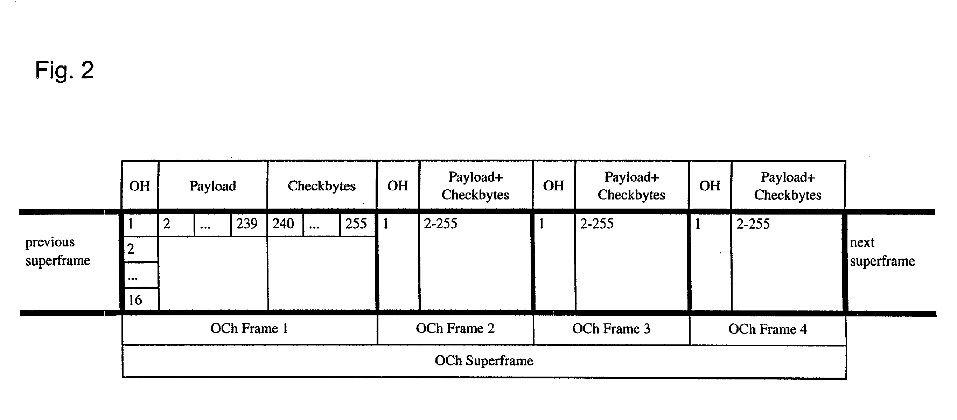

Fig. 2 depicts the logical structure of a data stream for optical channel transmission. A detailed description can be found in Ballintine, J.E. "Data Format and Generic Processing for OCh-OH", wave star, volume 420.200.11, issue 1.0, the disclosure of which is incorporated by reference herewith.

Referring back to Fig. 2, the data stream is organised into so called optical channel (OCh) superframes. Fig. 2 schematically shows one OCh super frame including four OCh frames, a portion of the previous super frame and a portion of the following super frame.

Each frame comprises 4080 bytes arranged as an overhead OH column, a payload section (Col. 2 to 239) and a check byte section (Col. 240 to 255) for error correction purposes. The frame period is approx. 81,63 kHz. The overhead column of the first frame contains a frame alignment word FAW used for the synchronisation of the device under test 50 to the incoming data stream. The overhead columns of the following frames are used for monitoring purposes in the network management. These bytes are monitored and/or changed in special modes of the device under test 50.

The payload section contains the client data. This can either be SONET/SDH or any other client signal format. The overhead bytes can be individually monitored and/or set through a control interface for ASIC device (CTLI-D) in the ASIC 50. The CTLI-D has access to a large number of registers where the device under test or ASIC 50 stores its internal states or will be configured with. An interrupt pin exists for signalling the assertion of an interrupt register. For better handling two types of interrupt registers are implemented. First, events indicate special occurrences during device under test operation, e.g. a buffer overflow and, second, deltas are used to signal changes of internal device under test states. At least one and, preferably every interrupt source is maskable via special bits.

In the testbench according to the invention the CPU interface (CIF) 20 has two tasks, controlling of registers inside the ASIC 50 and controlling of the testbench 10 itself. If an interrupt occurs, it is for example possible to read all the interrupt registers to find the triggering one and then reading the corresponding state bit. It is then possible to reconfigure the device under test 50 depending on the state, e.g. to change the data transmission mode or to reset the device under test. Alternatively, it is also possible to poll for a certain event or delta before the simulation setup changes.

Therefore, an environment has been developed and is described here, which communicates with the device under test 50 like the software in the "real" world. So the testbench 10 is able to react on device under test interrupts and to reconfigure the data generator(s) 30, the analyser(s) 40 and the device under test itself depending on its current, dynamic state. This reactivity is possible without a recompilation of the VHDL testbench, i.e. a CPU interface (CIF) 20 realised as an interpreter with a "soft-ware-like" command language is provided.

As can be best seen from Fig. 1, the CPU interface 20 is the heart of the testbench. The simulation is set and controlled by the CPU interface 20 interpreting the main command file 80. It contains a command sequence for ASIC register controlling and for settings and commands for the interaction of the testbench components. The data generator 30 and the data analyser 40 each have their own generic setup command file, e.g. with directory path settings for log or result files and default modes. They can be reconfigured during simulation by the CPU interface 20.

The data flow for the simulation or validation is surprisingly simple. First, the generator transmits or sends the input data to the device under test or ASIC 50 which sends the output data to the analyser 40. For proper interaction with the generator(s) 30, analyser(s) 40 and the device under test 50 some additional testbench features are provided.

First of all a command distribution process is introduced. It reacts on an event on a command output of the CPU interface 20, e.g. "gen payload 0xab", interpretes the string and sends the command "payload 0xab" to the data generator. From the next frame on, the generator will fill the payload area with 0xab in every byte.

Another process is the clock/reset generator which also is controlled by the CPU interface 20 via interactive command settings. The main clocks of the device under test 50 are mode dependent. During the simulation the clocks can be switched, e.g. to simulate a clock drift by sending the appropriate command from the CPU interface 20 over the command distribution process to the clock/reset control block. The simulation time is measured in generator frame pulses. E.g. for documentation purposes a process counts these frame-pulses and the analyser frame pulses, if they occur, and stamps them into a, preferably common, log file.

The generator frame pulse is sent to one pin of a generic input array of the CPU interface 20, which is called sync array. All the commands in the main CPU interface 20 command file are synchronised to this pulse. The CPU interface 20 has a command for waiting e.g. for 5 events on that sync input and then proceeds with the next command in the script. So the invention is completely time independent and synchronised to superframe boundaries. With this event based approach all the testcases or command files should work on every platform and must produce the same results.

All components write their results in the common simulation log file 70 in which the generator framecounter stamps mark the advance in "super frame times".

A further development of the invention with about 4M gates uses a sophisticated OCh format comprising or consisting of 10 multiplexed OCh payload data streams. So up to ten generators and analysers are used, one for each superframe payload data stream. They all are controlled by the CPU interface CIF and the command distribution block in the VHDL testbench.

### Methodology

In this section a short verification example is described in detail. The goal is to verify the next two requirements for the framing algorithm on top level.
- **Req. 70:** Out-Of-Frame state declaration O_OOF shall be declared valid when the Framing Marker is not found during thirteen consecutive OCh super-frames. O_OOF shall be declared invalid if the Framing Marker is found twice in two consecutive OCh superframes.
- **Req. 130:** O_LOF Set Control In the "In-Frame-Sync" state the number of OCh super-frames which are in O_OOF state are counted. After n OCh superframes, Loss Of Frame (O_LOF) shall be declared. The value of n shall be provisioned by SW in a five bit control register variable (O_LOFSET[4:0]) from 0 to 24.

On top level (chip boundaries) the CPU interface 20 is, in this example the only interface to communicate with the device under test 50 and to read/write, or set/reset registers, e.g. namely the O_OOF, O_LOFSET and O_LOF registers.

Table 1 shows an exemplary sequential and reusable command file 80 in CPU interface CIF language. Line 1 declares a local variable $lofset. Line 2 sets the register O_LOFSET to the value of the CPU interface CIF variable $lofset. Then the frame generator is reconfigured. Referring to line 3, the command "bitshift -8" forces a loss of one byte in the datastream. The result is a de-synchronisation of the device under test, as the received frame is one byte too short. In lines 4 and 5 the generator is configured with a wrong framing sequence or synchronisation word (normally the device under test searches for 8 times 0xf6 and 8 times 0x28). Therefore, the device under test should not be able to re-synchronise and it should send a O_OOFD event after 13 OCh Frames and the O_OOF state should have the value 1. The device under test 50 is in the state "Frame-Search" (see Req. 70).

Due to the O_LOFSET value set in line 2, 4 frames after the O_OOFD, the device under test should send a O_LOFD, if it is not possible to re-synchronise and that is the fact, as the correct framing sequence has been destroyed in lines 4 and 5. So it can be waited for a O_LOFD event at least for 5 frames (line 8 increments the CPU interface CIF variable $lofset and stores the result in the default CPU interface CIF variable $status).

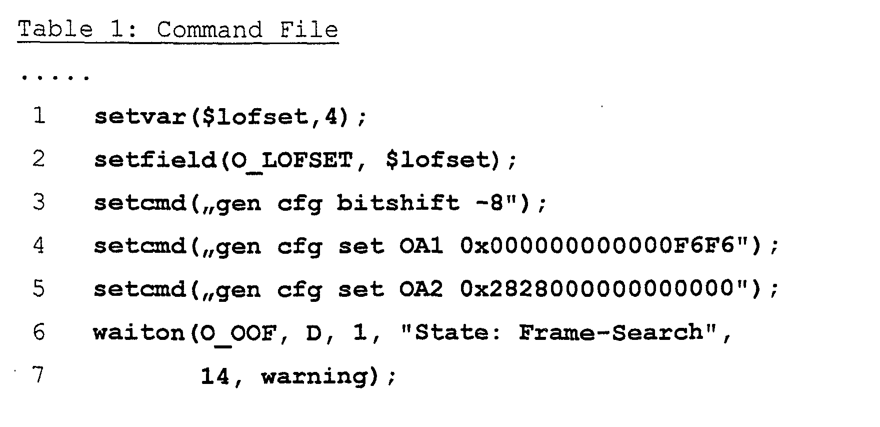

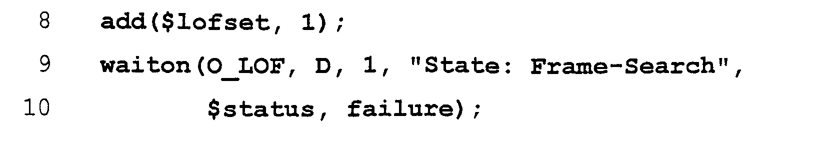

It should be clear to those skilled in the art that the command file shown in Table 1 merely describes one exemplary way through the state graph of the system or one exemplary solution and not all possible ones for the verification of the aforementioned two requirements. But for the top level verification that is sufficient, as the major possible cases can be simulated. However, it is possible to generate a command file in a semi-automatically way out of a formal specification.

The simulation result is shown in Table 2. The waiton procedure polls for the event on the O_OOFD. Meanwhile a time-out process counts the frames. The O_OOFD occurred before the timeout works. The requirement is fulfilled. If the event does not occur during 14 frames (line 7, Table 1), the waiton procedure will send a warning or in the case of waiting for the O_LOFD a failure in line 10, which will stop the simulation.

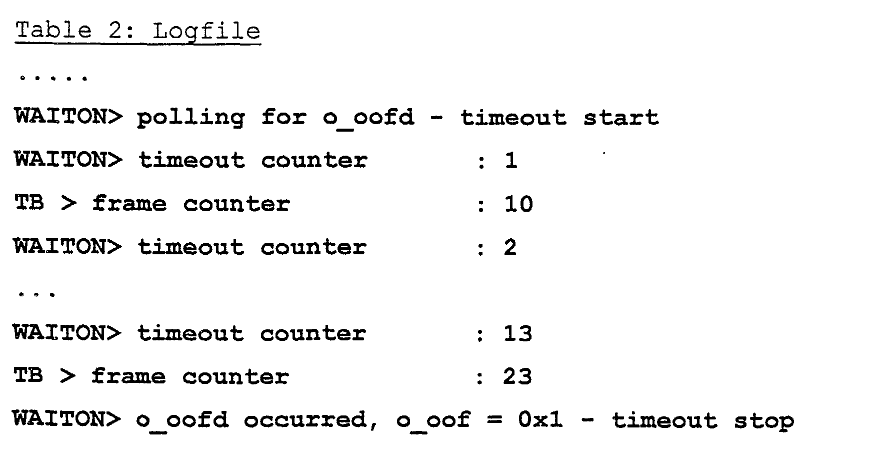

### Experience

The programmable testbench or validation environment according to the invention is considerably more complex than previously used testbenches. This is especially true for the data generators and analysers that react on run-time commands according to the invention, in contradiction to the previous execution of a static configuration script. The corresponding source code comprises or consists of approximately 34000 lines of C++. Its strict object oriented design allows for relatively easy extension towards new protocols. The foreign language interface of VHDL is used to offer a seamless integration into the standard simulation flow.

The controller interface has grown from a simple "symbolic name to bit pattern" converter to a fully-fledged interpreter for the CPU interface CIF language. Even though most of the technical difficulties are hidden from the users, the development of an appropriate design testbench requires more effort than before. In total, 30000 lines of VHDL are used for the complete testbench, including the CPU interface and the additional processes that were mentioned before.

Fortunately, this negative aspect is overcompensated by the simplified testcase generation process, i.e. the overall validation time is actually decreasing. Thanks to flexible interfaces the same test setups can be used on submodule and toplevel. This kind of hierarchical verification was infeasible with the previous purely pattern based approach. Because simulation control has switched from absolute times to an event-driven, data based mechanism it is also possible to create testcases that are reusable for different designs of the same ASIC family.

The testbench or validation environment according to the invention was evaluated first with a 1.2 million gates ASIC consisting of approx. 280000 lines of VHDL RT level code. Its behavior was defined by over 300 requirements. The testcase descriptions comprised another 20000 lines of code although the include file mechanism was extensively used by the validation engineers.

Because most of the tests could be performed on RT level the simulation performance was acceptable. A SUN Enterprise E4500/5500 with 18 GB RAM and the VHDL simulators Cadence ncsim 3.0 and MTI vsim 5.4b were used here. 125µs real-time (equal to one SONET/SDH frame) takes 7 to 11 minutes with ncsim, depending on the testbench activities. vsim is always 2 to 3 times slower than ncsim.

The same tests were also run with a Verilog gate level description. The hardware accelerated IKOS Voyager 3.21 obtained slightly better results with simulation times from 2 to 8 minutes per 125µs real-time. As a comparison: the gate level simulation with ncsim takes over 45 minutes. The same testbench was used throughout the entire validation.

While the testbench according to the invention with reactive simulation has already proved to be a major improvement for the daily validation work it does not tackle a fundamental problem of System-on-a-Chip design. Due to the vast amount of requirements (> 700 for the next project) it is at least very difficult to guarantee consistency on specification level. Thus, quite often, critical design errors are detected during chip-level validation, i.e. rather late in the development cycle. Additionally, it is very hard to develop testcases that really simulate the most extreme operating conditions because the true relationship between the various submodules remains unclear.

Most of the requirements describe the behavior of event-driven, reactive systems, i.e. they can be modelled as asynchronous automatons. With a formal description of these automatons mathematical methods to prove consistency can be used. If global goals are also formalised standard model-checking algorithms to prove the desired system properties can also be used.

The design specification, however, takes place on a very abstract level and the people involved usually have only limited knowledge about the ASIC development process. Thus, a programming-language-like specification environment would not be acceptable. A solution is the SCR approach directed towards formal specification. More detailed information about formal specification can be found in Heitmeyer, Constance L., James Kirby, and Bruce Labaw, "Tools for Formal Specification, Verification, and Validation of Requirements," Proceedings of 12th Annual Conference on Computer Assurance (COMPASS '97), June 16-19, 1997, Gaithersburg, MD and Heitmeyer, Constance L., Ralph D. Jeffords, and Bruce G. Labaw, "Automated Consistency Checking of Requirements Specifications," ACM Transactions on Software Engineering and Methodology 5, 3, July 1996, 231-261. C. Heitmeyer et al. have also reported ways to improve the quality of the design specification, see Gargantini, A. and C. Heitmeyer, "Using Model Checking to Generate Tests from Requirements Specifications," Proc., Joint 7th Eur. Software Engineering Conf. and 7th ACM SIG-SOFT Intern. Symp. on Foundations of Software Eng. (ESEC/FSE99), Toulouse, FR, Sept. 6-10, 1999. The disclosure of all three aforementioned references is incorporated by reference herewith.
Referring now to Fig. 3, an example of a formal design specification is shown, wherein SCR specifies the behaviour of an asynchronous automaton in a tabular format. Original requirements, e.g. of Lucent Technologies Inc. are often natural-language descriptions that can be easily formalised.

An R1090 mismatch and stable states during OSA-AIS are shown in Fig. 3. During OSA-AIS the status register STISTAB shall be fixed to zero if STIACCMO = 0. If STIACCMO = 1, STISTAB shall reflect the current status.

As a complete, formal device specification of this kind is also executable according to the invention on an automatic generation of behavioral VHDL models that can be used for early verification of system level requirements are also possible. These models can be replaced by the final RT level models step by step as the design progresses. This allows further parallelisation of design and validation tasks, thus shortening the overall design cycle.

Another embodiment of the invention comprises an automatic generation of the CPU interface CIF command files. The stimuli can be derived by exploration of the state graph. The state explosion problem due to the complexity of such systems appears to be the biggest obstacle for such an approach. Some ways for manual assistance as alternative to the complete automation appears to be helpful.

Summarising, a validation testbench or method, particularly for telecommunication circuits is provided by the invention disclosed herein. The reactive simulation based approach allows to deal with highest complexities without restricting too much with respect to the validation environment. This is achieved by using standard VHDL constructs. Due to performance issues, computational expensive algorithms are coded in C++, as before. The environment according to the invention, however, works without large and slow file I/O-operations and the input stimuli are preferably modified interactively.

Formal methods can be incorporated in the design specification phase in order to generate better quality testcases semi-automatically. Because of the size of the ASICs validated certain critical system properties can be proved on specification level and the correct implementation via conventional simulation runs can be assured.

It will be appreciated that the above-described embodiment of the invention has been set forth solely by way of example and illustration of the principles thereof and that further modifications and alterations may be made therein without thereby departing from the spirit and scope of the invention.

## Claims

1. A testbench (10) for the validation of a device under test (50) comprising
data providing means (30) for providing said device under test (50) with input data
a data analyser (40) for analysing output data from said device under test (50) and
a controller (20) adapted to be assigned to said device under test (50).

2. The testbench (10) according to claim 1, wherein said device under test (50) comprises a protocol-based data stream processing unit.

3. The testbench (10) according to claim 1 or 2, wherein said device under test (50) comprises an FPGA or an ASIC, in particular a multi-million-gate optical channel ASIC.

4. The testbench (10) according to one of the preceding claims, wherein said data providing means (30) and/or said data analyser (40) are adapted to be assigned to said device under test (50).

5. The testbench (10) according to one of the preceding claims, wherein said device under test (50) comprises a data input (58) and a data output (60) and wherein
said data providing means is adapted to feed said device under test (50) with said input data via said data input and
said data analyser (40) is adapted to receive said output data processed by said device under test (50) from said device under test (50) via said data output (60).

6. The testbench (10) according to one of the preceding claims, wherein said controller (20) is adapted to control and/or to observe said device under test (50).

7. The testbench (10) according to one of the preceding claims, wherein said controller (20) is assigned to said data providing means (30) and said data analyser (40).

8. The testbench (10) according to one of the preceding claims, wherein said controller (20) controls said data providing means (30) and/or said data analyser (40).

9. The testbench (10) according to one of the preceding claims, wherein said controller (20) is adapted to communicate interactively with said data analyser (40) and/or said data providing means (30) and/or said device under test (50).

10. The testbench (10) according to one of the preceding claims, wherein said controller (20) is adapted to react dynamically to data received by said data analyser (40) and is adapted to control said device under test (50) and/or said data providing means (30) in dependence on a result of said received data.

11. The testbench (10) according to one of the preceding claims, wherein said controller (20) is adapted to react dynamically to data receivable by said device under test (50) and is adapted to control said device under test (50) and/or said data providing means (30) in dependence on a result of said receivable data.

12. The testbench (10) according to one of the preceding claims, wherein said controller (20) is adapted to react to interrupts of the device under test (50) and to reconfigure the data providing means (30) in dependence on said reaction to said interrupts.

13. The testbench (10) according to claim 12, wherein said reconfiguration comprises a changing of the data transmission mode or a reset of the device under test (50) or a polling for an event or delta.

14. The testbench (10) according to one of the preceding claims, wherein said controller (20) comprises a control interface (24) for receiving event data from a status memory of said device under test (50) and/or for transmitting control data to said status memory.

15. The testbench (10) according to one of the preceding claims, wherein said controller (20) comprises an interface (26) for receiving one or more interrupts from said device under test (50).

16. The testbench (10) according to one of the preceding claims, being adapted for the validation of a device under test (50) comprising means for interrupt handling, particularly cascaded interrupt handling.

17. The testbench (10) according to one of the preceding claims, wherein said controller (20) is adapted to store interactive control commands and/or data received by said data analyser (40) and/or data receivable by said device under test (50) into a log file (70).

18. The testbench (10) according to one of the preceding claims, wherein said controller (20) is adapted to control a clock/reset generator.

19. The testbench (10) according to one of the preceding claims, wherein said controller (20) comprises an external CPU interface.

20. The testbench (10) according to one of the preceding claims, wherein said data providing means (30) comprises a data generator.

21. The testbench (10) according to one of the preceding claims, being software-based and programmed in a parallel program language, in particular in very high speed integrated circuit hardware description language (VHDL) or in C or in C++.

22. The testbench (10) according to one of the preceding claims, comprising means for automatic generation of behavioral VHDL models or automatic generation of controller (20) command files (80).

23. The testbench (10) according to one of the preceding claims, being event-driven.

24. The testbench (10) according to one of the preceding claims, providing a hierarchical verification, in particular said testbench (10) is adapted to be used on submodule or top level.

25. The testbench (10) according to one of the preceding claims, comprising
a plurality of data providing means (30) for providing said device under test (50) with input data and
a plurality of data analysers (40) for analysing output data from said device under test (50) and wherein said controller (20) controls said plurality of data providing means (30) and/or said plurality of data analysers (40).

26. Device for the validation of a device under test (50) comprising
said device under test (50) and
the testbench (10) according to one of the preceding claims.

27. A method for the validation of a device under test (50) comprising the steps of
providing digital data by data providing means (30),
transmitting said data from said data providing means (30) to said device under test (50),
processing said data by said device under test (50),
controlling said device under test (50) by a controller (20),
transmitting said processed data to a data analyser (40) and
analysing said data by said data analyser (40).

28. The method according to claim 27, comprising the steps of
receiving data from said data analyser (40) by said controller (20) and/or
receiving data from said data providing means (30) by said controller (20) and/or
receiving data from said device under test (50) by said controller (20) and/or
controlling said data analyser (40) by said controller (20) in dependence on a dynamic reaction to received data and/or
controlling said data providing means (30) by said controller (20) in dependence on a dynamic reaction to received data and/or
controlling said device under test (50) in dependence on a dynamic reaction to received data.

29. A computer program product directly loadable into an internal memory of a digital computer, comprising software code portions for performing the steps of the method according to claims 27 or 28 and/or for providing said data providing means (30), said data analyser (40) and said controller (20) comprised by said testbench (10) according to claims 1 to 26 when said product is run on the computer.
